# EUROPÄISCHE PATENTSCHRIFT

(11) **EP 3 384 689 B1**
(45) Veröffentlichungstag und Bekanntmachung des Hinweises auf die Patenterteilung: **23.06.2021**
(21) Anmeldenummer: 16798138.0
(22) Anmeldetag: 16.11.2016
(51) Int. Cl.: H03G 3/30, H03G 5/16, G06F 16/635, G06F 16/68, H04S 7/00

(54) **SYSTEM ZUR AUSGABE VON AUDIO-SIGNALEN SOWIE ZUGEHÖRIGES VERFAHREN UND EINSTELLVORRICHTUNG**
SYSTEM FOR OUTPUTTING AUDIO SIGNALS AND ASSOCIATED METHOD AND ADJUSTING DEVICE
SYSTÈME D'ÉMISSION DE SIGNAUX AUDIO, PROCÉDÉ AFFÉRENT ET DISPOSITIF DE RÉGLAGE

(30) Priorität: 01.12.2015 DE 102015223935
(43) Veröffentlichungstag der Anmeldung: 10.10.2018
(73) Patentinhaber: Fraunhofer-Gesellschaft zur Förderung der angewandten Forschung e.V., 80686 München (DE)
(72) Erfinder: APPELL, Jens Ekkehart, 26121 Oldenburg (DE)
(74) Vertreter: Zimmermann, Tankred Klaus
(86) Internationale Anmeldenummer: PCT/EP2016/077902
(87) Internationale Veröffentlichungsnummer: WO 2017/093024

(56) Entgegenhaltungen:
- EP-A2- 1 035 530
- DE-A1-102011 076 484
- US-A1- 2010 162 117
- US-B1- 6 792 092

## Beschreibung

Die vorliegende Erfindung bezieht sich auf ein System zur Ausgabe von Audio-Signalen. Weiterhin bezieht sich die Erfindung auf ein Verfahren zur Ausgabe von Audio-Signalen über eine Ausgabevorrichtung sowie auf eine Einstellvorrichtung für die Einstellung von Parameterwerten zur Ausgabe von Audio-Signalen.

Bei der Wiedergabe von Audio-Signalen, sei es Musik oder Sprache, zeigt sich eine starke Abhängigkeit von den Präferenzen des jeweiligen Nutzers bzw. Hörers hinsichtlich des gewünschten Klangs, z. B. bezüglich des Frequenzgangs, des dynamischen Verhaltens oder auch der Vorgaben für Signalverbesserungsverfahren. Die Einstellung der für die Wiedergabe einstellbaren Parameter erfolgt daher jeweils individuell, wobei ggf. auch vorhandene Hörprobleme zu berücksichtigen sind. Eine dem Stand der Technik entsprechende Vorrichtung ist in der DE 10 2011 076 484 A1 gezeigt.

Gleichzeitig hat der einzelne Hörer heutzutage eine Vielzahl von Ausgabevorrichtungen als Endgeräte (z. B. Lautsprecheranlagen, Fernseher, Radio, Computer, Mobiltelefone, Festnetztelefon, Autoradio usw.), Softwareprogramme (sog. Apps, z. B. für das Hören von Musik, von Podcasts oder für Videokonferenzen) und eine Vielzahl von Anwendungszenarien (z. B. das Hören von Musik oder von gesprochenen Texten, das Telefonieren oder das Teilnehmen an Videokonferenzen oder Chatsystemen) zur Verfügung, die auch jeweils unterschiedliche einstellbare Parameter aufweisen oder die jeweils andere Parameterwerte erforderlich machen.

Die optimale Einstellung der Parameter muss bei jeder Anwendung oder Endgerät bzw. bei jeder Kombination aus Endgerät und Anwendung für einen optimalen Hörgenuss eingestellt werden. Der dabei jeweils nötige Aufwand für den Nutzer ist enorm. Zugleich bedeutet der Aufwand der Bereitstellung entsprechender Nutzerschnittstellen ("User Interfaces") für das Einstellen der Parameter auf der Seite der Hersteller der Anwendung bzw. des Endgerätes einen Mehraufwand sowie Mehrkosten, so dass die Realisierung der eigentlich notwendige Einstellmöglichkeiten verzichtet wird.

Dieser Aufwand bzw. das Fehlen der notwendigen Einstellmöglichkeiten führt meist dazu, dass der Nutzer keine oder nur eine unvollständige Individualisierung vornimmt bzw. vornehmen kann, so dass er sich schlechtem Klang ausgesetzt sieht oder z. B. das Sprachverständnis leidet oder eine höhere Höranstrengung besteht.

Um den Aufwand zu reduzieren bzw. als Folge des fehlenden Willens zur Individualisierung oder schlicht aus Kostengründen ergibt sich somit, dass bei vielen Geräten oder Anwendungen nur sehr vereinfachte Möglichkeiten zur Klanganpassung (z. B. nur Lautstärke oder nur Höhen-/Tiefenregler) implementiert werden.

Insgesamt wird also das Potential der modernen Audiosignalverarbeitung, z. B. auch in Hinblick auf die Adaption an die Hörumgebung oder eine bei dem Hörer vorhandener Hörverlust, nicht immer ausgeschöpft.

Die Aufgabe der vorliegenden Erfindung besteht daher darin, die Individualisierung der Ausgabe von Audio-Signalen einfacher zu gestalten und dadurch für den Hörer komfortabler zu machen.

Die Aufgabe löst die Erfindung mit einem System zur Ausgabe von Audio-Signalen gemäß Anspruch 1 sowie einem Verfahren gemäß Anspruch 11.

Die in den Ansprüchen beschriebene Verwaltungsvorrichtung ist derartig konfiguriert, dass die Verwaltungsvorrichtung in dem Fall, dass die Verwaltungsvorrichtung abgespeicherte Parameterwerte für den Satz von Parametern im Datenspeicher gefunden hat, die abgespeicherten Parameterwerte für den Satz von Parametern an die erste Ausgabevorrichtung übermittelt und/oder aus den abgespeicherten Parameterwerten ermittelte Parameterwerte an die erste Ausgabevorrichtung übermittelt. Bei den einstellbaren Parametern handelt es sich beispielsweise um die Lautstärke, um die Einstellung von Höhen oder Bässen oder um die besondere Einstellung von einzelnen Frequenzbändern, Kennlinien zur Modifikation des Dynamikumfangs, Grad der Anwendung von Signalaufbereitungsalgorithmen usw.. Die einstellbaren Parameter können dabei auch z. B. Werte sein, mit denen man die Filterfunktion eines Equalizers ermittelt und einstellt. Das Ermitteln bezieht sich insbesondere auf das Berechnen von Parameterwerten, z. B. durch eine Mittelwertbild, durch eine Extra- oder Interpolation, durch Splinebildung oder durch eine Änderung einer Abtastrate usw.. Dies beinhaltet beispielsweise auch komplexe Parameter und Präferenzen, wie etwa dem Hörverlust eines Hörers/Benutzers, die dann zur Ermittlung von Einstellungen, wie den Parametern einer frequenzabhängigen Dynamikkompression, herangezogen werden.

In dem erfindungsgemäßen System wird eine (erste, alternative Bezeichnung ist aktuelle) Ausgabevorrichtung - als Endgerät - zur eigentlichen Ausgabe der Audio-Signale verwendet. Für die Ausgabe verfügt die Ausgabevorrichtung über mehrere einstellbare Parameter, deren Parameterwerte sich vorgeben lassen, und die insgesamt einen (ersten) Satz von Parameter bilden.

Weiterhin ist ein Datenspeicher vorgesehen, in dem Parameterwerte abspeicherbar sind. Vorzugsweise wird jeweils die Kombination aus Sätzen von Parametern und zugehörigen Parameterwerten abgespeichert.

Zudem ist noch eine Verwaltungsvorrichtung vorgesehen, die auf den Datenspeicher zugreift und die dort nach einem vorhandenen, d. h. abgespeicherten Satz von Parametern sucht, der entweder gleich dem Satz von Parametern der (ersten bzw. aktuellen) Ausgabevorrichtung ist oder der ähnlich zu diesem Satz ist. Ist ein solcher passender Satz von Parametern gefunden worden, so übermittelt die Verwaltungsvorrichtung die zu dem passenden Satz zugehörigen Parameterwerte an die (erste) Ausgabevorrichtung. Alternativ oder ergänzend übermittelt die Verwaltungsvorrichtung an die erste/aktuelle Ausgabevorrichtung Parameterwerte, die aus den abgespeicherten Parameterwerten ermittelt oder abgeleitet wurden. Aus den dem gefundenen Satz von Parametern zugeordneten und abgespeicherten Parameterwerten werden also andere Parameterwerte generiert und an die Ausgabevorrichtung übertragen. Die übermittelten - vorher gespeicherten oder ermittelten - Parameterwerte werden dann von der (ersten) Ausgabevorrichtung für die Ausgabe der Audio-Signale verwendet.

Die Erfindung sei - unter gleichzeitiger Diskussion von beispielhaften Ausgestaltungen - an einem praktischen Beispiel erläutert:
Der Benutzer bzw. Hörer stellt die Parameter einer Ausgabevorrichtung so ein, dass sich ein für ihn optimales Klangbild ergibt. Die zugehörigen Parameterwerte werden in dem Datenspeicher abgespeichert. Möchte der Hörer zu einem späteren Zeitpunkt sich noch einmal Audio-Signale über die Ausgabevorrichtung ausgeben lassen, so sucht die Verwaltungsvorrichtung in dem Datenspeicher nach dem relevanten Satz an Parametern und übermittelt die zugehörigen Parameterwerte an die Ausgabevorrichtung, die dann mit diesen Parameterwerten die Audio-Signale für den Hörer optimal - nämlich mit den von ihm eingestellten Parameterwerten - wiedergibt. Handelt es sich bei der Ausgabevorrichtung, für die der Hörer die optimale Einstellung vorgegeben hat, und bei der Ausgabevorrichtung, über die er aktuell die Audio-Signale hören möchte, um unterschiedliche, aber ähnliche Vorrichtungen, so findet sich in dem Datenspeicher auch nur ein ähnlicher Satz an Parametern. Für diesen Fall übermittelt die Verwaltungsvorrichtung Parameterwerte an die aktuelle Ausgabevorrichtung, die die Verwaltungsvorrichtung aus den abgespeicherten Parameterwerten ermittelt hat. Bei der Ermittlung werden beispielsweise für identische Parameter die jeweiligen Parameterwerte übermittelt. Bei unterschiedlichen Parametern wird z. B. ausgehend von anderen Parametern bzw. deren Parameterwerten die jeweiligen Parameterwerte ermittelt. Dies geschieht z. B. durch eine Extrapolation, durch eine Mittelwertbildung oder durch eine von anderen Parameterwerten ausgehende Abschätzung.

In einer Ausgestaltung hat das System eine Schnittstelle, um von einer Ausgabevorrichtung die getroffenen Parametereinstellungen zu erfassen. Ergänzend können über die Schnittstelle Informationen über die Umgebungssituation, d. h. über die Kontexte, in denen die Ausgabe der Audio-Signale stattfinden, und/oder über den jeweiligen Benutzer erfasst werden. Der Benutzer kann dabei auch in einer Gruppe von Individuen bestehen. Die Informationen können dabei eine gewisse Abstraktion aufweisen (wie etwas das Audiogramm eines Hörers) oder auch konkrete Werte sein.

In einer Ausgestaltung werden die relevanten Informationen offline erfasst und erst zu einem späteren Zeitpunkt an die Verwaltungsvorrichtung bzw. den Datenspeicher übertragen.

In einer weiteren Ausgestaltung ist eine Schnittstelle vorhanden, die die Übertragung der Parameterwerte an die aktuelle bzw. erste Ausgabevorrichtung erlaubt. In einer Ausgestaltung werden die Informationen offline und daher vorab vor der eigentlichen Ausgabe der Audio-Signale übertragen.

Mit anderen Worten: Die vorgegebenen - historischen - Parameterwerte für die Ausgabe mit einer Ausgabevorrichtung (in der Anmeldung z. B. bezeichnet als zweite Ausgabevorrichtung) werden für die - vorzugsweise automatische - Einstellung der Parameterwerte der Audio-Signal-Ausgabe über eine aktuell betroffene Ausgabevorrichtung (hier allgemein bezeichnet als erste Ausgabevorrichtung) verwendet.

Insgesamt hat das System für den Benutzer bzw. Hörer den großen Vorteil, dass er nicht für alle Ausgabevorrichtungen die Parameter einzeln einstellen muss, sondern dass das System dies ausgehend von vorhandenen Datensätzen für ihn übernimmt. Dabei werden nicht nur die Ausgabevorrichtungen oder Endgeräte berücksichtigt, bei denen der Benutzer schon einmal Einstellungen vorgenommen hat, sondern auch diejenigen, für die noch keine benutzerbezogene Anpassung vorgenommen worden ist. Daher entweder die direkte Ausgabe der abspeicherten Parameterwerte oder die Ausgabe der ermittelten oder abgeleiteten Parameterwerte.

Ein weiterer Vorteil besteht darin, dass das Einstellen der Parameter und die Anwendung der Parameterwerte voneinander getrennt sind, so dass die eingestellten Parameterwerte zu beliebigen Zeiten und unter beliebigen Anwendungen zur Verfügung stehen und so dass insbesondere auch eine automatische Ermittlung von Parameterwerten, z. B. in Form von Berechnungen möglich wird.

Ein Vorteil für die Hersteller von Ausgabevorrichtungen, also von Endgeräten, kann darin bestehen, auf spezielle Interfaces für das Einstellen der Geräte zu verzichten, da die Präferenzen bzw. Einstellungen zentral verwaltet werden.

Die folgende Ausgestaltung bezieht sich auf die Hinterlegung der Parameterwerte im Datenspeicher, auf den anschließend die Verwaltungsvorrichtung zugreifen kann.

Dabei weist das System ergänzend eine - in einer Ausgestaltung insbesondere nur temporär vorhandene - zweite Ausgabevorrichtung zur Ausgabe von Audio-Signalen auf. Die zweite Ausgabevorrichtung ist derartig konfiguriert, Audio-Signale mit vorgebbaren Parameterwerten eines zweiten Satzes von einstellbaren Parametern auszugeben. Weiterhin ist die Verwaltungsvorrichtung derartig konfiguriert, nach einem Vorgeben der Parameterwerte des zweiten Satzes von Parametern zumindest die eingestellten Parameterwerte in dem Datenspeicher abzuspeichern. Nach dem Vorgeben der Parameterwerte des zweiten Satzes von Parametern sind die vorgebbaren Parameterwerte des zweiten Satzes von einstellbaren Parametern auf eingestellte Parameter eingestellt. Die zweite (eine alternative Bezeichnung wäre: historische) Ausgabevorrichtung ist insbesondere vor der ersten (aktuellen) Ausgabevorrichtung Teil des Systems und dient dem Benutzer bzw. Hörer zum Einstellen der Parameter, die die Ausgabe der Audio-Signale beeinflussen. Sind die Einstellungen vorgenommen worden, d. h. hat der Benutzer die Parameterwerte für die zweite Ausgabevorrichtung vorgegeben, so speichert die Verwaltungsvorrichtung die Parameterwerte für die weitere Verwendung bei der ersten Ausgabevorrichtung ab. Bei dem Vorgeben der Parameterwerte handelt es sich insbesondere darum, dass ein Benutzer der zweiten Ausgabevorrichtung Einstellungen an der Ausgabevorrichtung vornimmt, so dass sich für ihn das optimale Klangbild ergibt.

In einer Ausgestaltung handelt es sich bei der ersten Ausgabevorrichtung und der zweiten Ausgabevorrichtung um unterschiedliche Ausgabevorrichtungen, die in einer Ausgestaltung zumindest zum gleichen Typ an Ausgabevorrichtungen gehören und die in einer alternativen Ausgestaltung unterschiedliche Typen sind. Der Typ der Ausgabevorrichtung bezieht sich in einer Ausgestaltung auf die Geräte an sich, d. h. ob es sich um Computer, Stereoanlagen oder z. B. um Smartphones handelt. Bei dem Typ handelt es sich in einer anderen Ausgestaltung um den gleichen Grundtyp, jedoch um unterschiedliche Versionen oder Klassen. In einer weiteren Ausgestaltung sind die erste Ausgabevorrichtung und die zweiten Ausgabevorrichtung gleich, z. B. die identische Ausgabevorrichtung wird zweimal mit dem System verbunden. In der letzten Ausgestaltung wird durch das System quasi ein Erinnern der Parameterwerte ermöglicht.

Je nach Ausgestaltung beziehen sich daher die abgespeicherten Parameterwerte der zweiten Ausgabevorrichtung auf gleiche, ähnliche oder unterschiedliche Sätze von Parametern wie der Satz von Parametern der ersten Ausgabevorrichtung.

Alternativ oder ergänzend werden die Parameterwerte direkt - und ohne den Umweg über die Einstellung an einer Ausgabevorrichtung - in dem Datenspeicher abgespeichert. Dies geschieht z. B. durch eine Schnittstelle, die eine direkte Eingabe von Parameterwerten der bei einer Ausgabevorrichtung einstellbaren Parameter erlaubt.

In einer Ausgestaltung ist vorgesehen, dass die Verwaltungsvorrichtung derartig konfiguriert ist, dass sie - z. B. direkt von der aktuellen bzw. ersten Ausgabevorrichtung - einliest, welche Parameter bei der ersten Ausgabevorrichtung einzustellen sind. Die Verwaltungsvorrichtung erhält daher die Informationen über den mit Parameterwerten zu füllenden ersten Satz von Parameterwerten.

Für eine weitere Verarbeitung der Parameterwerte oder für das Auffinden der Datensätze sieht es eine Ausgestaltung vor, dass die Verwaltungsvorrichtung derartig konfiguriert ist, die eingestellten Parameterwerte einem Typ der zweiten Ausgabevorrichtung und/oder einem Benutzer und/oder einer Umgebungssituation und/oder den auszugebenden Audio-Signalen und/oder einer Art der auszugebenden Audio-Signale zugeordnet in dem Datenspeicher abzuspeichern. Zu den Parameterwerten, die in einer Ausgestaltung bei der zweiten Ausgabevorrichtung eingestellt werden, wird in einer Variante entsprechend auch der Typ der Ausgabevorrichtung abgespeichert. Der Typ bezieht sich beispielsweise auf die zugehörigen Parameter oder auf die Möglichkeiten zur Einstellung der Parameter oder auch auf den Anwendungstyp.

Alternativ oder ergänzend werden die Parameterwerte einem jeweiligen Benutzer oder einer Umgebungssituation zugehörig abgespeichert. Die Umgebungssituation oder Hörsituation ist dabei die Umgebung, in der die Audio-Signale wiedergegeben werden. Hierbei sei verwiesen auf die Ausführungen in der DE 10 2011 076 484 A1. Die Umgebungssituation wirkt sich beispielsweise auf die jeweilige Lautstärke aus.

Zusätzlich ergänzend oder alternativ werden die Parameterwerte in Abhängigkeit von einem Typ oder einer Art der Audio-Signale abgespeichert. So werden die Audio-Signale beispielsweise als Sprach-Signale oder Musik-Signale, als Klassik-, Jazz- oder Pop-Signale, als Film-Signale usw. abgespeichert bzw. ggf. zunächst durch eine Eingabe vom Benutzer oder durch eine Auswertung der Audio-Signale klassifiziert. Die Art der Audio-Signale ist ggf. auch gemischt oder kann ggf. auch durch die Art der Anwendung bzw. die Endgeräte vorgegeben sein. So werden die Audio-Signale, die per Telefon übertragen werden, in aller Regel Sprach-Signale sein. Diese weitere Klassifizierung erlaubt eine weitere genaue Einstellung der Hörpräferenzen, die damit auch auf die jeweiligen Signale und deren Eigenschaften Rücksicht nehmen kann.

Die Zuordnung der Parameterwerte zu den Typen der Ausgabevorrichtungen, zu einzelnen Benutzern oder auch zu den jeweiligen Umgebungsbedingungen erlaubt eine entsprechende Auswertung oder Weiterverarbeitung der Parameterwerte. Dies vor allem für den Fall, dass nicht zu allen Parametern, die akut für die jeweilige Anwendung bzw. die jeweilige Ausgabevorrichtung erforderlich sind, Parameterwerte im Datenspeicher abgespeichert sind.

In einer Ausgestaltung ist die Verwaltungsvorrichtung derartig konfiguriert, bei der Suche im Datenspeicher nach den abgespeicherten Parameterwerten für den Satz von Parametern einen der ersten Ausgabevorrichtung zugeordneten Benutzer zu berücksichtigen. Der Benutzer ist dabei der Hörer, der sich z. B. angemeldet oder der gerade die Ausgabevorrichtung für die Ausgabe der Audio-Signale nutzen möchte. Die Berücksichtigung erfolgt, indem die Verwaltungsvorrichtung solche abgespeicherten Parameterwerte für Sätze von Parametern bevorzugt, die dem Benutzer oder Nutzern mit zu dem Benutzer ähnlichen Präferenzen zugeordnet sind. Die Präferenzen beziehen sich darauf, dass der Benutzer und die anderen Nutzer zu einer gleichen Gruppe von Hörern gehören (z. B. Klassik-oder Rockmusik-Freunde). Die Präferenzen beziehen sich alternativ darauf, dass Ähnlichkeiten in den Einstellungen, z. B. in der Bevorzugung des Bassbereichs oder von anderen Frequenzbändern besteht. Die Präferenzen können dabei ähnlich bis hin zur Gleichheit sein. Die Ähnlichkeit besteht ggf. darin, dass die Abweichungen innerhalb eines vorgebbaren Abweichungsbandes liegen.

In einer mit der vorherigen Ausgestaltung einhergehenden oder ggf. auch alternativen Ausgestaltung ist vorgesehen, dass die Verwaltungsvorrichtung derartig konfiguriert ist, bei der Suche im Datenspeicher nach den abgespeicherten Parameterwerten für den Satz von Parametern einen der ersten Ausgabevorrichtung zugeordneten Benutzer zu berücksichtigen, indem die Verwaltungsvorrichtung abgespeicherte Parameterwerte für Sätze von Parametern, die dem Benutzer, aber anderen Typen von Ausgabevorrichtungen zugeordnet sind, mit abgespeicherten Parameterwerten für Sätze von Parametern vergleicht, die anderen Nutzern und diesen Typen von Ausgabevorrichtungen zugeordnet sind, und abgespeicherte Parameterwerte für den Satz von Parametern aus dem Datenspeicher auswählt, die einem Nutzer zugeordnet sind, für die der Vergleich die größte Ähnlichkeit ergibt. Hier werden also auch andere Typen von Ausgabevorrichtungen berücksichtigt, insofern sich erst über den Vergleich der Parameterwerte für unterschiedliche Ausgabevorrichtungen bei den Nutzern bzw. dem Benutzer erst die allgemeinen Präferenzen herauskristallisieren lassen. Der Bezug auf die einzelnen Hörer setzt dabei voraus, dass die in dem Datenspeicher abgespeicherten Daten auch den einzelnen Nutzern bzw. Benutzern zugeordnet sind. So ist in einer Ausgestaltung vorgesehen, dass sich der aktuelle Benutzer mit seiner aktuellen Ausgabevorrichtung an der Verwaltungsvorrichtung anmeldet.

In einer Ausgestaltung ist vorgesehen, dass die Verwaltungsvorrichtung derartig konfiguriert ist, bei der Suche im Datenspeicher nach den abgespeicherten Parameterwerten für den Satz von Parametern eine aktuelle Umgebungssituation an der ersten Ausgabevorrichtung zu berücksichtigen, indem die Verwaltungsvorrichtung abgespeicherte Parameterwerte für Sätze von Parametern bevorzugt, die der aktuellen Umgebungssituation ähnlichen Umgebungssituationen zugeordnet sind. Die Bevorzugung besteht dabei darin, dass die zugeordneten Daten bzw. Parameterwerte eine höhere Priorität bei der Suche erhalten. Hier werden insbesondere die Parameterwerte bevorzugt, die sich auf gleiche oder ähnliche Umgebungssituationen beziehen. Dabei handelt es sich beispielsweise um eine Autofahrt, um das Abspielen in einem geschlossenen oder offenen Raum, um die Signal-Wiedergabe in einem leeren oder gefüllten Raum, die Sprachwiedergabe auf einem Bahnsteig bei einfahrendem Zug usw..

In einer alternativen oder ergänzenden Ausgestaltung ist vorgesehen, dass die Verwaltungsvorrichtung derartig konfiguriert ist, bei der Suche im Datenspeicher nach den abgespeicherten Parameterwerten für den Satz von Parametern die auszugebenden Audio-Signale zu berücksichtigen, indem die Verwaltungsvorrichtung abgespeicherte Parameterwerte für Sätze von Parametern bevorzugt, die den auszugebenden Audio-Signalen ähnlichen Audio-Signalen zugeordnet sind. In dieser Ausgestaltung werden daher die Parameterwerte bevorzugt, die sich auf ähnliche Signaltypen oder Signalarten beziehen. Dabei handelt es sich beispielsweise um Sprach-Signale im Gegensatz zu Musik-Signalen oder um Hörspiel-Signale im Gegensatz zu Telefonaten usw.. In dieser Ausgestaltung wird also berücksichtigt, dass auch die Audio-Signale an sich Einfluss auf die jeweilige Hörpräferenz haben können. So werden bei Sprach-Signalen beispielsweise andere Frequenzbereiche verstärkt als bei Musik.

Weiterhin sieht eine Ausgestaltung es vor, dass die Verwaltungsvorrichtung derartig konfiguriert ist, dass die Verwaltungsvorrichtung in dem Fall, dass dem Datenspeicher zu dem ersten Satz von Parametern ein Parameterwert fehlt, anhand der im Datenspeicher abgespeicherten Parameterwerte zumindest den fehlenden Parameterwert ermittelt. Diese Ausgestaltung bezieht sich auf den Fall, dass der erste Satz von Parametern der ersten Ausgabevorrichtung wenigstens einen Parameter umfasst, zu dem der Datenspeicher keinen Parameterwert aufweist, der also fehlt. Für diesen Fall generiert die Verwaltungsvorrichtung den fehlenden Parameterwert, indem sie aus den vorhandenen Parameterwerten den fehlenden Parameterwert ermittelt. Dies geschieht beispielsweise, in dem aus den vorhandenen Parameterwerten ein Mittelwert erzeugt oder eine Extra- oder Interpolation vorgenommen wird.

Je nach Situation können auch mehrere Parameterwerte fehlen oder es kann sogar der Fall vorliegen, dass es zu einem kompletten Satz von Parametern keinen entsprechenden passenden Satz im Datenspeicher gibt. Für den Fall des vollständigen Fehlens eines Satzes von Parametern ist in einer Ausgestaltung vorgesehen, dass die Verwaltungsvorrichtung eine Meldung ausgibt. Dies z. B. für die Situation, dass kein auch nur annäherungsweise vergleichbarer Satz von Parametern vorhanden ist. Alternativ werden auch bei einem vollständig fehlenden Satz von Parametern die Parameterwerte aus gespeicherten Parameterwerten ermittelt.

In einer sich anschließenden Ausgestaltung ist die Verwaltungsvorrichtung derartig konfiguriert, bei der Ermittlung des fehlenden Parameterwerts die einem Benutzer zugeordneten und in dem Datenspeicher abgespeicherten Parameterwerte bevorzugt zu berücksichtigen.

In einer Ausgestaltung werden für die Ermittlung des fehlenden Parameterwerts oder der fehlenden Parameterwerte oder sogar aller Parameterwerte für einen kompletten Satz von Parametern nur die einem Benutzer zugeordneten Parameterwerte herangezogen. Für den Benutzer werden dabei die Audio-Signale über die erste/aktuelle Ausgabevorrichtung ausgegeben. In dieser Ausgestaltung werden somit die besonderen Vorlieben eines Benutzers in Form der abgespeicherten Parameterwerte bevorzugt oder insbesondere nur für die Ermittlung der fehlenden Parameterwerte herangezogen. Für diese Ausgestaltung ist es daher vorteilhaft, wenn zu den Parameterwerten auch der jeweils zugehörige Benutzer abgespeichert wird. Weiterhin ist vorteilhafterweise eine Möglichkeit realisiert, über die sich der Benutzer bei dem System bzw. bei der Verwaltungsvorrichtung bekannt machen kann.

Für die folgende Ausgestaltung liegt insbesondere der Fall vor, dass in dem Datenspeicher kein Satz an Parametern vorhanden ist, der gleich dem ersten Satz von Parametern der ersten Ausgabevorrichtung ist.

Die Ausgestaltung sieht vor, dass die Verwaltungsvorrichtung derartig konfiguriert ist, in dem Fall, dass die Verwaltungsvorrichtung in dem Datenspeicher einen Satz von Parametern gefunden hat, der ähnlich dem ersten Satz von Parametern ist, die zugehörigen und abgespeicherten Parameterwerte an den ersten Satz von Parametern anzupassen und die angepassten Parameterwerte an die erste Ausgabevorrichtung zu übermitteln. Die Verwaltungsvorrichtung adaptiert daher die Parameterwerte des Satzes von Parametern, der dem Satz von Parametern der ersten Ausgabevorrichtung ähnlich ist, so dass sie zu dem ersten (aktuell für die Ausgabe der Audio-Signale erforderlichen) Satz von Parametern passen, um von der ersten Ausgabevorrichtung für die Ausgabe der Audio-Signale verwendet zu werden. So werden beispielsweise die Parameterwerten von ähnlichen Parametern übernommen.

In der folgenden Ausgestaltung werden die Parameterwerte, die einem Benutzer zugeordnet sind, zu einem abstrakten Gesamtbild gebündelt. So ist in einer Ausgestaltung die Verwaltungsvorrichtung derartig konfiguriert, ausgehend von den einem Benutzer zugeordneten und in dem Datenspeicher abgespeicherten Parameterwerten ein Benutzerprofil für den Benutzer zu erstellen. Ein Benutzerprofil beschreibt die Vorlieben des betroffenen Benutzers auf einer von den Ausgabevorrichtungen oder Umgebungsbedingungen losgelösten abstrakten Ebene, um z. B. leichter fehlende Parameterwerte ermitteln zu können. Die Ermittlung des Benutzerprofils erfolgt z. B. mit Verfahren zum dynamischen Lernen. Dabei können die Parameter auf der konkreten Ebene und auf der abstrakten Ebene ggf. miteinander kombiniert werden. So können beispielsweise für eine Situation die Parameterwerte für einen Satz von Parametern aus dem allgemeinen bzw. abstrakten Rahmen eines Benutzerprofils herausfallen und ggf. gerade daher für die Anwendung in einer solchen Situation zwingend erforderlich sein. So könnte beispielsweise ein Nutzer es bevorzugen, dass bei einem einfahrenden Zug (oder allgemein bei "lauten Nebengeräuschen") das Sprachsignal von einem Mobiltelefon sehr stark verstärkt wird, wohingegen ein anderer Nutzer keinesfalls sehr laute Signale hören mag und daher ein Nicht-Verstehen des Anrufs in Kauf nimmt.

In einer Ausgestaltung weist das System - z. B. nur temporär - eine vierte Ausgabevorrichtung zur Ausgabe von Audio-Signalen auf, wobei die vierte Ausgabevorrichtung derartig konfiguriert ist, Audio-Signale mit vorgebbaren Parameterwerten eines vierten Satzes von einstellbaren Parametern auszugeben. Weiterhin ist die Verwaltungsvorrichtung derartig konfiguriert, dass sie ausgehend von dem erstellten Benutzerprofil Parameterwerte für den vierten Satz von Parametern der vierten Ausgabevorrichtung ermittelt und an die vierte Ausgabevorrichtung übermittelt. Ausgehend von dieser Ausgestaltung wird in einer weiteren Variante die Suche nach einem geeigneten Satz von Parametern für die vierte Ausgabevorrichtung ausgelassen und es werden direkt unter Verwendung des mindestens einen Benutzerprofils die Parameterwerte für den vierte Satz von Parametern für die Verwendung bei der vierten Ausgabevorrichtung ermittelt und dann an die vierte Ausgabevorrichtung übermittelt. Die vierte Ausgabevorrichtung ist somit auch eine aktuelle Ausgabevorrichtung wie die erste Ausgabevorrichtung, wobei jedoch die Parameterwerte speziell über die Benutzerprofile ermittelt werden.

In der Erfindung kann daher in einer alternativen Variante auf die Suche nach den Sätzen von Parametern verzichtet werden, indem direkt mit den abstrakten Benutzerprofilen gearbeitet wird, um die aktuell benötigten Parameterwerte ausgehend von den Benutzerprofilen zu ermitteln.

In einer weiteren Ausgestaltung ist die Verwaltungsvorrichtung derartig konfiguriert, ausgehend von dem für den Benutzer erstellten Benutzerprofil ein Benutzerprofil für einen anderen Benutzer zu ermitteln. Das Benutzerprofil für den anderen Benutzer beschränkt sich in einer Ausgestaltung auf die Parameterwerte für einen Satz von Parametern. Die Anwendung der Übertragung von Hörpräferenzen besteht in einer Ausgestaltung darin, dass die Parameterwerte von unterschiedlichen Benutzern miteinander verglichen werden und dass bei einem sich ergebenden ähnlichen Benutzerprofil z. B. die Parameterwerte eines Nutzers mit einer Ausgabevorrichtung und/oder in einer Umgebungsbedingung für einen anderen Benutzer verwendet werden. Dies davon ausgehend, dass ansonsten beide Nutzer unter zumindest ähnlichen oder gleichen Bedingungen vergleichbare Parameterwerte vorgegeben haben.

In einer Ausgestaltung ist vorgesehen, dass der Datenspeicher cloud-basiert ausgestaltet ist. Der Datenspeicher wird also zumindest teilweise über eine Cloud realisiert. Diese Ausgestaltung betont noch mehr, dass die (zentrale) Verwaltung der Daten und die Anwendung der Daten räumlich voneinander getrennt sind.

Der Datenspeicher, der z. B. in Form einer Cloud leichter zugänglich ist, erlaubt es in einer Ausgestaltung einer Mehrzahl von Benutzern, die abgespeicherten Parametwerte und/oder erzeugten Benutzerprofile und/oder Algorithmen zur Ermittlung von Parameterwerten zu ändern und vorzugsweise zu verbessern.

Weiterhin löst die Erfindung die Aufgabe durch ein Verfahren zur Ausgabe von Audio-Signalen über eine Ausgabevorrichtung, wobei das Verfahren zumindest die folgenden Schritte umfasst: dass nach einem Satz von Parameterwerten für einen Satz von Parametern gesucht wird, der einem Satz von einstellbaren Parametern der Ausgabevorrichtung gleich oder ähnlich ist, dass in dem Fall, dass Parameterwerte für den Satz von Parametern gefunden worden sind, die Parameterwerte und/oder daraus ermittelte Parameterwerte an die Ausgabevorrichtung übermittelt werden, und dass die Audio-Signale über die Ausgabevorrichtung unter Anwendung der übermittelten Parameterwerte ausgegeben werden.

Die obigen Ausführungen zu dem System bzw. dessen Ausgestaltungen und Erläuterungen gelten entsprechend auch für das Verfahren bzw. können die Ausgestaltungen des Verfahrens durch entsprechende Vorrichtungsvarianten realisiert werden, so dass die Ausführungen zu dem Verfahren entsprechend für das System gelten.

Weiterhin bezieht sich die Erfindung auf ein Computerprogramm mit einem Programmcode zur Durchführung des Verfahrens nach einem der obigen Ansprüche bzw. Ausgestaltungen ausgehend von den Ausführungen zum System.

Weiterhin löst die Erfindung die Aufgabe durch eine Einstellvorrichtung für die Einstellung von vorgebbaren Parameterwerten eines ersten Satzes von einstellbaren Parametern einer Ausgabevorrichtung zur Ausgabe von Audio-Signalen mit den vorgebbaren Parameterwerten. Die Einstellvorrichtung weist dabei mindestens einen Datenspeicher zum Speichern von Parameterwerten und mindestens eine Verwaltungsvorrichtung auf. Dabei ist die Verwaltungsvorrichtung derartig konfiguriert, auf den Datenspeicher zuzugreifen. Weiterhin ist die Verwaltungsvorrichtung derartig konfiguriert, im Datenspeicher nach einem abgespeicherten Parameterwerten für einen Satz von Parametern zu suchen, der gleich dem ersten Satz von Parametern oder der ähnlich dem ersten Satz von Parametern ist. Schließlich ist die Verwaltungsvorrichtung derartig konfiguriert, dass die Verwaltungsvorrichtung in dem Fall, dass die Verwaltungsvorrichtung abgespeicherte Parameterwerte für den Satz von Parametern im Datenspeicher gefunden hat, die abgespeicherten Parameterwerte für den Satz von Parametern und/oder aus denselben ermittelte Parameterwerte an die erste Ausgabevorrichtung übermittelt. Die Ermittlung der Parameterwerte besteht dabei in einer Ausgestaltung in der direkten Übermittlung an eine Ausgabevorrichtung und besteht in einer alternativen oder ergänzenden Ausgestaltung in einer Berechnung bzw. allgemein Ermittlung (z. B. durch den Zugriff auf eine Datentabelle) der aktuell erforderlichen Parameterwerte.

Die obigen Ausführungen zu dem System bzw. dessen Ausgestaltungen und Erläuterungen gelten entsprechend auch für die Einstellvorrichtung als Teil eines solchen Systems. Die Einstellvorrichtung und wenigstens eine Ausgabevorrichtung ergänzen sich dabei insbesondere zu dem obigen System, so dass auch die entsprechenden Ausgestaltungen und Ausführungen bezüglich des Systems für die Einstellvorrichtung geiten.

Im Einzelnen gibt es eine Vielzahl von Möglichkeiten, das erfindungsgemäße System sowie das erfindungsgemäße Verfahren und die erfindungsgemäße Einstellvorrichtung auszugestalten und weiterzubilden. Dazu wird verwiesen einerseits auf die Patentansprüche, andererseits auf die folgende Beschreibung von Ausführungsbeispielen in Verbindung mit der Zeichnung. Es zeigen:
- Fig. 1: schematisch ein System zur Ausgabe von Audio-Signalen in einer ersten Ausgestaltung,
- Fig. 2: schematisch ein System in einer zweiten Ausgestaltung und
- Fig. 3: ein Flussdiagram eines Beispiels für das Verfahren.

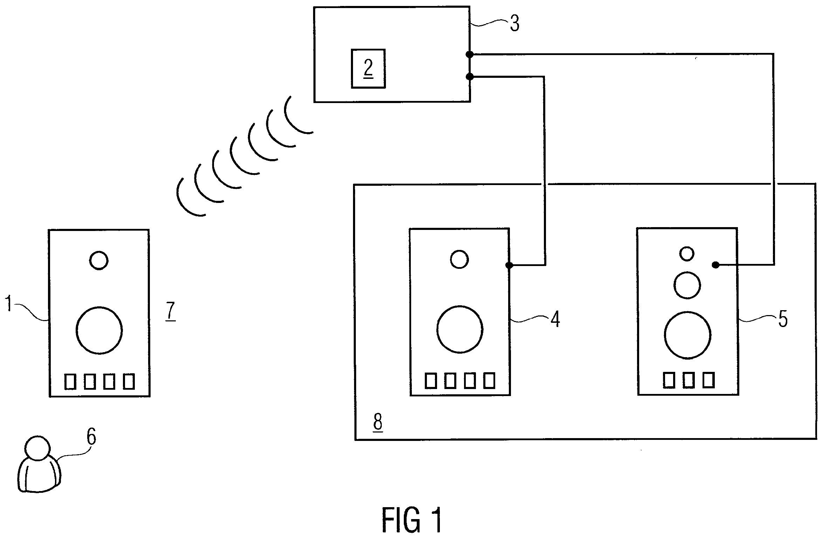

Die Fig. 1 zeigt schematisch ein beispielhaftes System zur Ausgabe von Audio-Signaien.

Die erste Ausgabevorrichtung 1 wird hier durch einen Lautsprecher repräsentiert, der beispielhaft vier Schalter für die Vorgabe von Parameterwerten von vier Parametern haben soll. Die vier Parameter bilden damit den ersten Satz von einstellbaren Parametern.

Unterschiedliche Parameterwerte für unterschiedliche Sätze von Parametern sind in einem Datenspeicher 2 hinterlegt, der hier ein Teil einer Verwaltungsvorrichtung 3 ist. Der zentrale Datenspeicher 2 erlaubt die Bedienung bzw. Einstellung von unterschiedlichen, verteilt angeordneten Ausgabevorrichtungen. Dabei können sich die Ausgabevorrichtungen hinsichtlich ihrer konkreten Ausgestaltung - also hinsichtlich ihrer Hardware - voneinander unterscheiden oder hinsichtlich der auf dem gleichen Gerät betriebenen Anwendung, durch die dann das gleiche Gerät gleichsam zu unterschiedlichen Vorrichtungen wird. So kann beispielweise ein Computer zum Abspielen von Musik oder zur Durchführung einer Videokommunikation verwendet werden, wodurch sich jeweils unterschiedliche Ausgabevorrichtungen ergeben.

In dem gezeigten Beispiel ist die Verwaltungsvorrichtung 3 derartig konfiguriert, dass sie in dem Datenspeicher 2 nach einem abgespeicherten Satz von Parametern sucht, der zu dem ersten Satz von Parametern der ersten Ausgabevorrichtung 1 passt. Dabei bedeutet "passen", dass der gefundene (also abgespeicherte und damit gleichsam historische) Satz dem ersten (also mit Parameterwerten zu füllende und aktuelle) Satz gleicht oder dass der gefundene Satz dem ersten Satz ähnlich ist. Die Ähnlichkeit kann darin bestehen, dass sich die Sätze auf ähnliche Endgeräte beziehen und/oder dass die Sätze zum gleichen Benutzer bzw. Hörer gehören und/oder dass die Sätze zu ähnlichen Audiosignalen (also z. B. reine Sprache oder klassische Musik) und/oder dass eine Mehrzahl von Parametern gleich ist. Je nach Anwendungsfall ist die Ähnlichkeit somit zu definieren.

Findet die Verwaltungsvorrichtung 3 einen passenden Satz von Parametern, so übermittelt sie - hier angedeutet durch Funkwellen - die zugehörigen Parameterwerte an die erste Ausgabevorrichtung 1, die daher ohne ein direktes Eingreifen des Benutzers 6 über passende Parameterwerte verfügt.

Die Sätze von Parametern und deren Werte stammen in der gezeigten Ausgestaltung von einer zweiten Ausgabevorrichtung 4 und einer dritten Ausgabevorrichtung 5. Dabei soll die zweite Ausgabevorrichtung 4 gleich der ersten Ausgabevorrichtung 1 sein und soll die dritte Ausgabevorrichtung 5 unterschiedlich zu der ersten Ausgabevorrichtung 1 sein. Die Unterschiede beziehen sich dabei auf das Endgerät (veranschaulicht durch zwei im Gegensatz zu drei Membranen) selbst, aber auch auf die Anzahl der einstellbaren Parameter (vier Parameter im Gegensatz zu drei Parametern). Die Verbindung zwischen der Verwaltungsvorrichtung 3 und der zweiten 4 und dritten Ausgabevorrichtung 5 erfolgt dabei beispielhaft über Kabel.

Hat daher ein Benutzer 6 die Einstellung der Parameter an der zweiten Ausgabevorrichtung 4 oder an der dritten Ausgabevorrichtung 5 (beide Ausgabevorrichtungen 4, 5 sind daher relativ zur ersten, aktuellen Ausgabevorrichtung 1 historische Ausgabevorrichtungen) vorgenommen, so stehen ihm diese Parameterwerte auch an der ersten Ausgabevorrichtung 1 automatisch zur Verfügung. Die Parameterwerte lassen sich dabei entweder direkt übernehmen (hier von der zweiten Ausgabevorrichtung 4) oder ergeben sich über eine Anpassung aus den abgespeicherten, historischen Parameterwerten (hier von der dritten Ausgabevorrichtung 5).

Ändert der Benutzer anschließend an der ersten Ausgabevorrichtung 1 die Parameterwerte, so werden diese wieder in den Datenspeicher 2 übernommen und abgespeichert. Die unterschiedlichen Parameterwerte sind in dem Beispiel darauf zurückzuführen, dass sich die erste Ausgabevorrichtung 1 in einer freien Umgebungssituation 7 befindet, wohingegen die zweite Ausgabevorrichtung 4 und die dritte Ausgabevorrichtung 5 in einer geschlossenen - hier angedeutet durch den Kasten - Umgebungssituation 8 angeordnet sind.

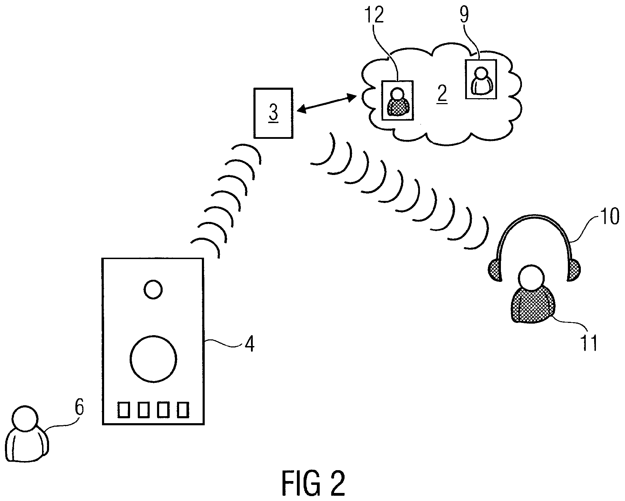

In der Fig. 2 ist ein System dargestellt, in dem der Benutzer 6 an der zweiten Ausgabevorrichtung 4 die Parameterwerte für den zweiten Satz von Parametern, der vier Parameter umfasst, vorgibt. Diese Parameterwerte werden per Funk an die Verwaltungsvorrichtung 3 übertragen und in dem Datenspeicher 2, der hier in einer Cloud realisiert ist, abgespeichert. Zudem erzeugt die Verwaltungsvorrichtung 3 aus den Parameterwerten ein Benutzerprofil 9 für den Benutzer 6, das ebenfalls in dem Datenspeicher 2 abgespeichert wird.

Die Verwaltungsvorrichtung 3 verwendet das abgespeicherte Benutzerprofil 9, um daraus die Parameterwerte für eine vierte Ausgabevorrichtung 10 und einen anderen Benutzer 11 (oder allgemein Nutzer) zu ermitteln. Dabei beziehen sich die einen Parameter auf einen Lautsprecher (zweite Ausgabevorrichtung 4) und die anderen Parameter auf einen Kopfhörer (vierte Ausgabevorrichtung 10). Für diesen Zweck werden beispielsweise die Parameterwerte, die sich auf die Lautstärke beziehen, entsprechend herunterskaliert.

Weiterhin werden auch die Parameterwerte für einen anderen Benutzer 11 umgerechnet. Für diese Umrechnung werden das in dem Datenspeicher 2 abgespeicherten Benutzerprofile 9 des einen Benutzers 6 und das Benutzerprofil 12 des anderen Benutzers 11 miteinander verglichen, um einen Abgleich der Parameterwerte zu ermöglichen.

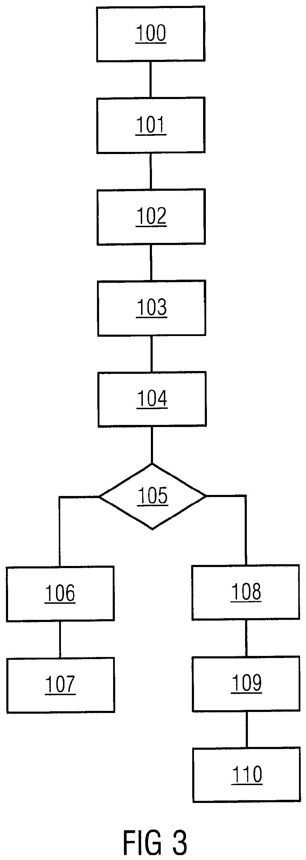

Die Fig. 3 zeigt einen schematischen Ablauf des erfindungsgemäßen Verfahrens.

Im Schritt 100 stellt ein Benutzer an einer Ausgabevorrichtung (oben bezeichnet als zweite Ausgabevorrichtung) die Parameter so ein, dass sich für ihn der optimale Klang ergibt. Die Parameterwerte sind dabei spezifisch für ihn als Benutzer, aber auch für die Ausgabevorrichtung bzw. für den Typ, zu dem die Ausgabevorrichtung gehört, sowie für die gegebene Umgebungs- oder Hörsituation.

Die Parameterwerte werden im Schritt 101 abgespeichert.

Nun möchte der Benutzer über eine andere Ausgabevorrichtung Audio-Signale ausgegeben bekommen, wofür er die Ausgabe im Schritt 102 startet.

Dafür wird im Schritt 103 abgefragt, welche Parameter bei der anderen Ausgabevorrichtung einstellbar sind. Es wird also ermittelt, um welchen erforderlichen Satz von Parametern es sich handelt.

Daraufhin wird im Schritt 104 die Menge der abgespeicherten Daten nach einem Satz von Parametern durchsucht, der dem erforderlichen Satz von Parametern gleicht oder ähnlich dazu ist.

In Abhängigkeit davon, was für ein Satz von Parametern gefunden wird, folgen unterschiedliche Schritte nach Schritt 105.

Ist der gleiche Satz von Parametern gefunden worden, so werden im Schritt 106 die zugehörigen Parameterwerte an die Ausgabevorrichtung übergeben und so gibt im Schritt 107 die Ausgabevorrichtung die Audio-Signale mit den passenden Parameterwerten aus.

Gleichen sich die Sätze von Parametern nicht, so werden im Schritt 108 aus den abgespeicherten Parameterwerten die erforderlichen Parameterwerte ermittelt. So werden beispielsweise bei gleichen Parametern die Parameterwerte übernommen und werden bei voneinander abweichenden Parametern Näherungsmethoden zur Berechnung bzw. Ermittlung herangezogen. Liegen beispielweise nur die Einstellungen für zwei Frequenzbereiche vor, sind jedoch die Einstellungen von drei Frequenzbereichen erforderlich, so werden für den fehlenden Frequenzbereich die Einstellungen, d. h. die Parameterwerte, durch Extra- oder Interpolation ermittelt.

Die ermittelten Parameterwerte werden im Schritt 109 an die Ausgabevorrichtung übermittelt, um dort im Schritt 110 für die Ausgabe der Audio-Signale Verwendung zu finden.

Insgesamt erlaubt es die Erfindung je nach Ausgestaltung, Parameterwerte zwischen unterschiedlichen Ausgabevorrichtungen, aber auch zwischen unterschiedlichen Benutzern/Hörern oder Hörergruppen zu übertragen. Die historischen Parameter werden dabei aus den Einstellungen an Ausgabevorrichtungen gewonnen oder können auch unmittelbar als reine Daten abgespeichert werden (also z. B. ein Audiogramm). Die aktuell erforderlichen Parameterwerte werden entweder unverändert aus den abgespeicherten Parameterwerten entnommen oder werden aus den abgespeicherten Daten bzw. durch die Verwendung von erzeugten Benutzerprofilen ermittelt. Aus dem vorhandenen historischen Datenmaterial findet also insbesondere eine Anpassung an die Möglichkeiten der aktuellen Ausgabevorrichtung statt. Alternativ oder ergänzend zu Benutzerprofilen werden auch Profile für Ausgabevorrichtungen bzw. Typen von Ausgabevorrichtungen und/oder für Umgebungssituationen erzeugt.

Die Erfindung erlaubt daher die Übertragung bzw. Anwendung der jeweiligen persönlichen Klangpräferenz auf die jeweils aktuelle Audio-Situation. Weiterhin können die Parameterwerte auch auf die jeweilige Art der Audio-Signale bzw. der Audi-Signale selbst bezogen sein und sich darin voneinander unterscheiden. Handelt es sich bei den Audio-Signalen z. B. um Jazz, so können die Parameterwerte unterschiedlich zu denen für die Wiedergabe eines Klavierstücks von J.S.Bach sein. In einem weiteren Beispiel bevorzugt ein Nutzer für die Wiedergabe von Sprache mit viel Höhen, weil er eine Hochtonschwerhörigkeit hat und so besser verstehen kann. Bei Musik als anderem Audio-Signal-Typ bevorzugt er jedoch das Hervorheben des Bass, weil dies seinem Geschmack entgegen kommt. Daher würde beispielsweise eine PodCast-App andere Parameterwerte gesendet bekommen als eine Music-Player-App.

Die Ausgabevorrichtungen beziehen sich dabei generell auf Geräte (TV, Handy, Computer, Stereoanlage, Hörgerät usw.) oder auch auf die jeweils durchzuführende Anwendung (Abspielen von Musik, Telefonie, Abspielen von Filmen usw.) als auch die entsprechenden Softwarelösungen wie PodCast-Player, VoiceOverIP-Telefonie-Apps usw..

Weiterhin ist die Verwaltungsvorrichtung auch lernfähig, um die von ihr verwendeten Algorithmen zu verbessern und an die Erfordernisse anzupassen. So passt die Verwaltungsvorrichtung in einer Ausgestaltung die Benutzerprofile an jede weitere Vorgabe von Parameterwerten automatisch an.

Funktionale Merkmale, die mit Bezug auf eine Vorrichtung beschrieben worden sind, stellen - wie für Fachleute offensichtlich - jeweils auch Merkmale eines entsprechenden Verfahrens dar, das konfiguriert ist, um eine entsprechende Funktionalität zu liefern. Umgekehrt stellen Merkmale, die bei einem Verfahren besprochen worden sind, jeweils auch Merkmale einer entsprechenden Vorrichtung dar, die konfiguriert ist, um entsprechende Merkmale auszuführen.

## Patentansprüche

1. System zur Ausgabe von Audio-Signalen,
mit einer ersten Ausgabevorrichtung (1) einer Mehrzahl von unterschiedlichen Typen von Ausgabevorrichtungen zur Ausgabe von Audio-Signalen,
wobei die erste Ausgabevorrichtung (1) derartig konfiguriert ist, Audio-Signale mit vorgebbaren Parameterwerten eines ersten Satzes von einstellbaren Parametern auszugeben,
mit mindestens einem Datenspeicher (2) zum Speichern von Parameterwerten und mit mindestens einer Verwaltungsvorrichtung (3),
wobei die Verwaltungsvorrichtung (3) derartig konfiguriert ist, auf den Datenspeicher (2) zuzugreifen,
wobei die Verwaltungsvorrichtung (3) derartig konfiguriert ist, im Datenspeicher (2) nach abgespeicherten Parameterwerten für einen Satz von Parametern zu suchen, der gleich dem ersten Satz von Parametern oder der ähnlich dem ersten Satz von Parametern ist,
wobei die Verwaltungsvorrichtung (3) derartig konfiguriert ist, bei der Suche im Datenspeicher (2) nach den abgespeicherten Parameterwerten für den Satz von Parametern einen der ersten Ausgabevorrichtung (1) zugeordneten Benutzer (6) zu berücksichtigen, indem die Verwaltungsvorrichtung (3) abgespeicherte Parameterwerte für Sätze von Parametern, die dem Benutzer, aber anderen Typen von Ausgabevorrichtungen zugeordnet sind, mit abgespeicherten Parameterwerten für Sätze von Parametern vergleicht, die anderen Nutzern und diesen Typen von Ausgabevorrichtungen zugeordnet sind, und Sätze von Parametern von denjenigen der anderen Nutzer zu bevorzugen, die ähnliche Präferenzen wie der Benutzer aufweisen, wobei Präferenzen zwischen dem Benutzer und den anderen Nutzern dann ähnlich sind, wenn der Benutzer und die anderen Nutzer zu einer gleichen Hörergruppe gehören,
wobei die Verwaltungsvorrichtung (3) derartig konfiguriert ist, dass die Verwaltungsvorrichtung (3) in dem Fall, dass die Verwaltungsvorrichtung (3) abgespeicherte Parameterwerte für den Satz von Parametern im Datenspeicher (2) gefunden hat, die abgespeicherten Parameterwerte für den Satz von Parametern und/oder aus denselben ermittelte Parameterwerte an die erste Ausgabevorrichtung (1) übermittelt.

2. System nach Anspruch 1,
**dadurch gekennzeichnet,**
**dass** das System eine zweite Ausgabevorrichtung (4) zur Ausgabe von Audio-Signalen aufweist,
**dass** die zweite Ausgabevorrichtung (4) derartig konfiguriert ist, Audio-Signale mit vorgebbaren Parameterwerten eines zweiten Satzes von einstellbaren Parametern auszugeben, und
**dass** die Verwaltungsvorrichtung (3) derartig konfiguriert ist, nach einem Vorgeben der Parameterwerte des zweiten Satzes von Parametern, so dass die vorgebbaren Parameterwerte des zweiten Satzes von einstellbaren Parametern auf eingestellte Parameter eingestellt sind, zumindest die eingestellten Parameterwerte des zweiten Satzes von Parametern in dem Datenspeicher (2) abzuspeichern.

3. System nach Anspruch 1 oder 2,
**dadurch gekennzeichnet,**
**dass** die Verwaltungsvorrichtung (3) derartig konfiguriert ist, die eingestellten Parameterwerte einem Typ der zweiten Ausgabevorrichtung (4) und/oder einem Benutzer (6) und/oder einer Umgebungssituation (7, 8) und/oder den auszugebenden Audio-Signalen und/oder einer Art der auszugebenden Audio-Signale zugeordnet in dem Datenspeicher (2) abzuspeichern.

4. System nach einem der Ansprüche 1 bis 3,
**dadurch gekennzeichnet,**
**dass** die Verwaltungsvorrichtung (3) derartig konfiguriert ist, bei der Suche im Datenspeicher (2) nach den abgespeicherten Parameterwerten für den Satz von Parametern einen der ersten Ausgabevorrichtung (1) zugeordneten Benutzer (6) zu berücksichtigen, indem die Verwaltungsvorrichtung (3) abgespeicherte Parameterwerte für Sätze von Parametern, die dem Benutzer, aber anderen Typen von Ausgabevorrichtungen zugeordnet sind, mit abgespeicherten Parameterwerten für Sätze von Parametern vergleicht, die anderen Nutzern und diesen Typen von Ausgabevorrichtungen zugeordnet sind, und abgespeicherte Parameterwerte für den Satz von Parametern aus dem Datenspeicher auswählt, die einem Nutzer zugeordnet sind, für die der Vergleich die größte Ähnlichkeit ergibt.

5. System nach Anspruch 1 bis 4,
**dadurch gekennzeichnet,**
**dass** die Verwaltungsvorrichtung (3) derartig konfiguriert ist, bei der Suche im Datenspeicher (2) nach den abgespeicherten Parameterwerten für den Satz von Parametern eine aktuelle Umgebungssituation an der ersten Ausgabevorrichtung (1) zu berücksichtigen, indem die Verwaltungsvorrichtung (3) abgespeicherte Parameterwerte für Sätze von Parametern bevorzugt, die der aktuellen Umgebungssituation ähnlichen Umgebungssituationen zugeordnet sind.

6. System nach Anspruch 1 bis 5,
**dadurch gekennzeichnet,**
**dass** die Verwaltungsvorrichtung (3) derartig konfiguriert ist, bei der Suche im Datenspeicher (2) nach den abgespeicherten Parameterwerten für den Satz von Parametern die auszugebenden Audio-Signale zu berücksichtigen, indem die Verwaltungsvorrichtung (3) abgespeicherte Parameterwerte für Sätze von Parametern bevorzugt, die den auszugebenden Audio-Signalen ähnlichen Audio-Signalen zugeordnet sind.

7. System nach einem der Ansprüche 1 bis 6,
**dadurch gekennzeichnet,**
**dass** die Verwaltungsvorrichtung (3) derartig konfiguriert ist, ausgehend von den einem Benutzer (6) zugeordneten und in dem Datenspeicher (2) abgespeicherten Parameterwerten ein Benutzerprofil (9) für den Benutzer (6) zu erstellen.

8. System nach Anspruch 7,
**dadurch gekennzeichnet,**
**dass** eine vierte Ausgabevorrichtung (10) zur Ausgabe von Audio-Signalen vorhanden ist,
wobei die vierte Ausgabevorrichtung (10) derartig konfiguriert ist, Audio-Signale mit vorgebbaren Parameterwerten eines vierten Satzes von einstellbaren Parametern auszugeben, und
**dass** die Verwaltungsvorrichtung (3) derartig konfiguriert ist, ausgehend von dem erstellten Benutzerprofil (9) Parameterwerte für den vierten Satz von Parametern zu ermitteln und an die vierte Ausgabevorrichtung (10) zu übermitteln.

9. System nach Anspruch 7 oder 8,
**dadurch gekennzeichnet,**
**dass** die Verwaltungsvorrichtung (3) derartig konfiguriert ist, ausgehend von dem für den Benutzer (6) erstellten Benutzerprofil (9) ein Benutzerprofil für einen anderen Benutzer (11) zu ermitteln.

10. System nach einem der Ansprüche 1 bis 9,
**dadurch gekennzeichnet,**
**dass** der Datenspeicher (2) cloud-basiert ausgestaltet ist.

11. Verfahren zur Ausgabe von Audio-Signalen,
wobei eine erste Ausgabevorrichtung (1) einer Mehrzahl von unterschiedlichen Typen von Ausgabevorrichtungen zur Ausgabe von Audio-Signalen Audio-Signale mit vorgebbaren Parameterwerten eines ersten Satzes von einstellbaren Parametern ausgibt,
wobei eine Verwaltungsvorrichtung (3) auf einen Datenspeicher (2) zugreift, wobei die Verwaltungsvorrichtung (3) im Datenspeicher (2) nach abgespeicherten Parameterwerten für einen Satz von Parametern sucht, der gleich dem ersten Satz von Parametern oder der ähnlich dem ersten Satz von Parametern ist, wobei die Verwaltungsvorrichtung (3) bei der Suche im Datenspeicher (2) nach den abgespeicherten Parameterwerten für den Satz von Parametern einen der ersten Ausgabevorrichtung (1) zugeordneten Benutzer (6) berücksichtigt, indem die Verwaltungsvorrichtung (3) abgespeicherte Parameterwerte für Sätze von Parametern von anderen Nutzern für andere Typen von Ausgabevorrichtungen berücksichtigt, indem die Verwaltungsvorrichtung (3) abgespeicherte Parameterwerte für Sätze von Parametern, die dem Benutzer, aber anderen Typen von Ausgabevorrichtungen zugeordnet sind, mit abgespeicherten Parameterwerten für Sätze von Parametern vergleicht, die anderen Nutzern und diesen Typen von Ausgabevorrichtungen zugeordnet sind, und Sätze von Parametern von denjenigen der anderen Nutzern bevorzugt, die ähnliche Präferenzen wie der Benutzer aufweisen, wobei Präferenzen zwischen dem Benutzer und den anderen Nutzern dann ähnlich sind, wenn der Benutzer und die anderen Nutzer zu einer gleichen Hörergruppe gehören,
wobei die Verwaltungsvorrichtung (3) in dem Fall, dass die Verwaltungsvorrichtung (3) abgespeicherte Parameterwerte für den Satz von Parametern im Datenspeicher (2) gefunden hat, die abgespeicherten Parameterwerte für den Satz von Parametern und/oder aus denselben ermittelte Parameterwerte an die erste Ausgabevorrichtung (1) übermittelt.

## Claims

1. A system for outputting audio signals,
comprising a first output device (1) of a plurality of different types of output devices for outputting audio signals,
wherein the first output device (1) is configured to output audio signals having predeterminable parameter values of a first set of settable parameters, comprising at least one data storage (2) for storing parameter values, and comprising at least one administration device (3),
wherein the administration device (3) is configured to access the data storage (2), wherein the administration device (3) is configured to search the data storage (2) for stored parameter values for a set of parameters which equals the first set of parameters or is similar to the first set of parameters,
wherein the administration device (3) is configured to take into account, when searching the data storage (2) for the stored parameter values for the set of parameters, a user (6) associated with the first output device (1) in that the administration device (3) compares stored parameter values for sets of parameters which are associated with the user but with other types of output devices to stored parameter values for sets of parameters which are associated with other users and with said types of output devices, and to prefer sets of parameter values of those of the other users who have preferences similar to those of the user, wherein preferences between the user and the other users are similar when the user and the other users belong to a same group of listeners,
wherein the administration device (3) is configured such that, in case the administration device (3) has found stored parameter values for the set of parameters in the data storage (2), the administration device (3) transfers the stored parameter values for the set of parameters and/or parameter values determined therefrom to the first output device (1).

2. The system in accordance with claim 1,
**characterized in that:**
the system comprises a second output device (4) for outputting audio signals,
the second audio device (4) is configured to output audio signals having predeterminable parameter values of a second set of settable parameters, and the administration device (3) is configured to store, after predetermining the parameter values of the second set of parameters such that the predeterminable parameter values of the second set of settable parameters are set to set parameters, at least the set parameter values of the second set of parameters in the data storage (2).

3. The system in accordance with claim 1 or 2,
**characterized in that:**
the administration device (3) is configured to store the set parameter values in the data storage (2) in a manner in which they are associated with a type of the second output device (4) and/or with a user (6) and/or with an environmental situation (7, 8) and/or with the audio signals to be output, and/or with a type of the audio signals to be output.

4. The system in accordance with any of claims 1 to 3,
**characterized in that:**
the administration device (3) is configured to take into account, when searching the data storage (2) for the stored parameter values for the set of parameters, a user (6) associated with the first output device (1) **in that** the administration device (3) compares stored parameter values for sets of parameters which are associated with the user but with different types of output devices, to stored parameter values for sets of parameters which are associated with other users and said ypes of output devices, and selects from the data storage stored parameter values for the set of parameters which are associated with a user, for which the comparison yields in the maximum amount of similarity.

5. The system in accordance with any of claims 1 to 4,
**characterized in that:**
the administration device (3) is configured to take into account, when searching the data storage (2) for the stored parameter values for the set of parameters, a current environmental situation at the first output device (1) **in that** the administration device (3) prefers stored parameter values for sets of parameters which are associated with environmental situations similar to the current environmental situation.

6. The system in accordance with any of claims 1 to 5,
**characterized in that:**
the administration device (3) is configured to take into account, when searching the data storage (2) for the stored parameter values for the set of parameters, the audio signals to be output **in that** the administration device (3) prefers stored parameter values for sets of parameters which are associated with audio signals similar to the audio signals to be output.

7. The system in accordance with any of claims 1 to 6,
**characterized in that:**
the administration device (3) is configured to form a user profile (9) for the user (6) on the basis of the parameter values associated with a user (6) and stored in the data storage (2).

8. The system in accordance with claim 7,
**characterized in that:**
there is a fourth output device (10) for outputting audio signals,
wherein the fourth output device (10) is configured to output audio signals having predeterminable parameter values of a fourth set of settable parameters, and
the administration device (3) is configured to determine, on the basis of the user profile (9) formed, parameter values for the fourth set of parameters and to transfer same to the fourth output device (10).

9. The system in accordance with claim 7 or 8,
**characterized in that:**
the administration device (3) is configured to determine a user profile for another user (11) on the basis of the user profile (9) formed for the user (6).

10. The system in accordance with any of claims 1 to 9,
**characterized in that:**
the data storage (2) is implemented to be cloud-based.

11. A method for outputting audio signals,
wherein a first output device (1) of a plurality of different types of output devices for outputting audio signals outputs audio signals having settable parameters of a first set of settable parameters,
wherein an administration device (3) accesses a data storage (2),
wherein the administration device (3) searches the data storage (2) for stored parameter values for a set of parameters which equals the first set of parameters or is similar to the first set of parameters,
wherein the administration device (3) takes into account, when searching the data storage (2) for the stored parameter values for the set of parameters, a user (6) associated with the first output device (1) in that the administration device (3) takes into account stored parameter values for sets of parameters of other users for other types of output devices, in that the administration device (3) compares stored parameter values for sets of parameters which are associated with the user but with other types of output devices to stored parameter values for sets of parameters which are associated with other users and with said types of output devices, and prefers sets of parameter values of those of the other users who have preferences similar to those of the user, wherein preferences between the user and the other users are similar when the user and the other users belong to a same group of listeners,
wherein the administration device (3) transfers, in case the administration device (3) has found stored parameter values for the set of parameters in the data storage (2), the stored parameter values for the set of parameters and/or parameter values determined therefrom to the first output device (1).

## Revendications

1. Système d'émission de signaux audio,
avec un premier dispositif d'émission (1) d'une pluralité de types différents de dispositifs d'émission destinés à émettre des signaux audio,
dans lequel le premier dispositif d'émission (1) est configuré pour émettre des signaux audio avec des valeurs de paramètre pouvant être prédéterminées d'un premier ensemble de paramètres réglables,
avec au moins une mémoire de données (2) destinée à mémoriser des valeurs de paramètre et avec au moins un dispositif de gestion (3),
dans lequel le dispositif de gestion (3) est configuré pour accéder à la mémoire de données (2),
dans lequel le dispositif de gestion (3) est configuré pour rechercher dans la mémoire de données (2) des valeurs de paramètre mémorisées pour un ensemble de paramètres qui est identique au premier ensemble de paramètres ou qui est similaire au premier ensemble de paramètres,
dans lequel le dispositif de gestion (3) est configuré pour tenir compte, lors de la recherche dans la mémoire de données (2) des valeurs de paramètre mémorisées pour l'ensemble de paramètres, d'un utilisateur (6) associé au premier dispositif d'émission (1) en ce que le dispositif de gestion (3) compare les valeurs de paramètre mémorisées pour les ensembles de paramètres qui sont associés à l'utilisateur, mais à d'autres types de dispositifs d'émission, avec les valeurs de paramètre mémorisées pour les ensembles de paramètres qui sont associés à d'autres utilisateurs et à ces types de dispositifs d'émission, et pour préférer les ensembles de paramètres de ceux des autres utilisateurs qui présentent des préférences similaires à celles de l'utilisateur, où les préférences entre l'utilisateur et les autres utilisateurs sont similaires lorsque l'utilisateur et les autres utilisateurs appartiennent à un même groupe d'auditeurs,
dans lequel le dispositif de gestion (3) est configuré de sorte que le dispositif de gestion (3) transmette, au cas où le dispositif de gestion (3) a trouvé dans la mémoire de données (2) des valeurs de paramètre mémorisées pour l'ensemble de paramètres, les valeurs de paramètre mémorisées pour l'ensemble de paramètres et/ou des valeurs de paramètre déterminées à partir de ces dernières au premier dispositif d'émission (1).

2. Système selon la revendication 1,
**caractérisé par le fait**
**que** le système présente un deuxième dispositif d'émission (4) destiné à émettre des signaux audio,
**que** le deuxième dispositif d'émission (4) est configuré pour émettre des signaux audio avec des valeurs de paramètre pouvant être prédéterminées d'un deuxième ensemble de paramètres réglables,
et
**que** le dispositif de gestion (3) est configuré pour mémoriser dans la mémoire de données (2), après une prédétermination des valeurs de paramètre du deuxième ensemble de paramètres de sorte que les valeurs de paramètre pouvant être prédéterminées du deuxième ensemble de paramètres réglables soient réglées à des paramètres réglés, au moins les valeurs de paramètres réglées du deuxième ensemble de paramètres.

3. Système selon la revendication 1 ou 2,
**caractérisé par le fait**
**que** le dispositif de gestion (3) est configuré pour mémoriser dans la mémoire de données (2) les valeurs de paramètre réglées de manière associée à un type du deuxième dispositif d'émission (4) et/ou à un utilisateur (6) et/ou à une situation environnementale (7, 8) et/ou aux signaux audio à émettre et/ou à un type de signaux audio à émettre.

4. Système selon l'une des revendications 1 à 3,
**caractérisé par le fait**
**que** le dispositif de gestion (3) est configuré pour tenir compte, lors de la recherche dans la mémoire de données (2) des valeurs de paramètre mémorisées pour l'ensemble de paramètres, d'un utilisateur (6) associé au premier dispositif d'émission (1) en ce que le dispositif de gestion (3) compare les valeurs de paramètre mémorisées pour les ensembles de paramètres qui sont associés à l'utilisateur, mais à d'autres types de dispositifs d'émission, avec des valeurs de paramètre mémorisées pour les ensembles de paramètres qui sont associés à d'autres utilisateurs et à ces types de dispositifs d'émission, et sélectionne dans la mémoire de données les valeurs de paramètre mémorisées pour les ensembles de paramètres qui sont associés à un utilisateur pour lesquelles la comparaison donne comme résultat la plus grande similitude.

5. Système selon les revendications 1 à 4,
**caractérisé par le fait**
**que** le dispositif de gestion (3) est configuré pour tenir compte, lors de la recherche dans la mémoire de données (2) des valeurs de paramètre mémorisées pour l'ensemble de paramètres, d'une situation environnementale actuelle au niveau du premier dispositif d'émission (1) en ce que le dispositif de gestion (3) préfère les valeurs de paramètre mémorisées pour les ensembles de paramètres qui sont associés à des situations environnementales similaires à la situation environnementale actuelle.

6. Système selon les revendications 1 à 5,
**caractérisé par le fait**
**que** le dispositif de gestion (3) est configuré pour tenir compte, lors de la recherche dans la mémoire de données (2) des valeurs de paramètre mémorisées pour l'ensemble de paramètres, des signaux audio à émettre en ce que le dispositif de gestion (3) préfère les valeurs de paramètre mémorisées pour les ensembles de paramètres qui sont associés à des signaux audio similaires aux signaux audio à émettre.

7. Système selon l'une des revendications 1 à 6,
**caractérisé par le fait**
**que** le dispositif de gestion (3) est configuré pour créer, en partant des valeurs de paramètre associées à un utilisateur (6) et mémorisées dans la mémoire de données (2), un profil d'utilisateur (9) pour l'utilisateur (6).

8. Système selon la revendication 7,
**caractérisé par le fait**
**qu'**il est présent un quatrième dispositif d'émission (10) destiné à émettre des signaux audio,
dans lequel le quatrième dispositif d'émission (10) est configuré pour émettre des signaux audio avec des valeurs de paramètre pouvant être prédéterminées d'un quatrième ensemble de paramètres réglables, et
**que** le dispositif de gestion (3) est configuré pour déterminer, en partant du profil d'utilisateur créé (9), des valeurs de paramètre pour le quatrième ensemble de paramètres et pour les transmettre au quatrième dispositif d'émission (10).

9. Système selon la revendication 7 ou 8,
**caractérisé par le fait**
**que** le dispositif de gestion (3) est configuré pour déterminer, en partant du profil d'utilisateur (9) créé pour l'utilisateur (6), un profil d'utilisateur pour un autre utilisateur (11).

10. Système selon l'une des revendications 1 à 9,
**caractérisé par le fait**
**que** la mémoire de données (2) est conçue sur base du cloud.

11. Procédé d'émission de signaux audio,
dans lequel un premier dispositif d'émission (1) d'une pluralité de types différents de dispositifs d'émission destinés à émettre des signaux audio émet des signaux audio avec des valeurs de paramètres pouvant être prédéterminées d'un premier ensemble de paramètres réglables,
dans lequel un dispositif de gestion (3) accède à une mémoire de données (2),
dans lequel le dispositif de gestion (3) recherche dans la mémoire de données (2) des valeurs de paramètre mémorisées pour un ensemble de paramètres qui est identique au premier ensemble de paramètres ou qui est similaire au premier ensemble de paramètres,
dans lequel le dispositif de gestion (3) tient compte, lors de la recherche dans la mémoire de données (2) des valeurs de paramètres mémorisées pour l'ensemble de paramètres, d'un utilisateur (6) associé au premier dispositif d'émission (1) en ce que le dispositif de gestion (3) tient compte des valeurs de paramètre mémorisées pour les ensembles de paramètres d'autres utilisateurs pour d'autres types de dispositifs d'émission, en ce que le dispositif de gestion (3) compare les valeurs de paramètre mémorisées pour les ensembles de paramètres associés à l'utilisateur, mais à d'autres types de dispositifs d'émission avec les valeurs de paramètre mémorisées pour les ensembles de paramètres qui sont associés à d'autres utilisateurs et à ces types de dispositifs d'émission, et préfère les ensembles de paramètres de ceux des autres utilisateurs qui présentent des préférences similaires à celles de l'utilisateur, où les préférences entre l'utilisateur et les autres utilisateurs sont similaires lorsque l'utilisateur et les autres utilisateurs appartiennent à un même groupe d'auditeurs,
dans lequel le dispositif de gestion (3) est configuré de sorte que le dispositif de gestion (3) transmette, au cas où le dispositif de gestion (3) a trouvé dans la mémoire de données (2) des valeurs de paramètre mémorisées pour l'ensemble de paramètres, les valeurs de paramètre mémorisées pour l'ensemble de paramètres et/ou des valeurs de paramètre déterminées à partir de ces dernières au premier dispositif d'émission (1).
